# EUROPÄISCHE PATENTSCHRIFT

(11) **EP 1 783 552 B1**
(45) Veröffentlichungstag und Bekanntmachung des Hinweises auf die Patenterteilung: **07.10.2015**
(21) Anmeldenummer: 05023952.4
(22) Anmeldetag: 03.11.2005
(51) Int. Cl.: G03F 7/12, G03F 7/004, G03F 7/038

(54) **Photopolymerisierbare Zusammensetzung zur Herstellung von Druckformen**
Photopolymerizable composition for producing printing forms
Composition photopolymérisable pour la fabrication de formes d'impression

(43) Veröffentlichungstag der Anmeldung: 09.05.2007
(73) Patentinhaber: Kissel & Wolf GmbH, D-69168 Wiesloch (DE)
(72) Erfinder: Wittemann, Günter, 69234 Dielheim (DE)
(74) Vertreter: Paul, Dieter-Alfred

(56) Entgegenhaltungen:
- DD-A- 293 487
- US-B1- 6 194 481
- US-B1- 6 261 700
- US-B1- 6 743 936
- DATABASE WPI Section Ch, Week 199321 Derwent Publications Ltd., London, GB; Class A89, AN 1993-169898 XP002376107 & JP 05 100433 A (TOYO INK MFG CO) 23. April 1993 (1993-04-23) & JP 05 100433 A (TOYO INK MFG CO) 23. April 1993 (1993-04-23)

## Beschreibung

Die Erfindung betrifft ein photopolymerisierbares Schablonenmaterial zur Herstellung von Siebdruck Formen, das Nanopartikel mit Chemisch vernetzbaren Oberflächengruppen enthält.

Beim Siebdruckverfahren wird ein Siebgewebe mit einem für UV-Licht empfindlichem wasserlöslichen Schablonenmaterial beschichtet, das entweder aus einer Emulsion oder aus einem aus einer Emulsion vorgefertigten Film besteht. Nach dem Trocknen des mit dem Schablonenmaterial beschichteten Siebgewebes wird auf dieses eine bildmäßige Darstellung durch ein Diapositiv mit UV-Licht projiziert. Die geschwärzten Teile des Diapositivs lassen kein UV-Licht durch, so daß das Schablonenmaterial insoweit nicht belichtet wird und dort wasserlöslich bleibt. Die UVbelichteten Stellen vernetzen und werden wasserunlöslich. Nach dem Belichtungsprozeß wird die Druckschablone durch Entwicklung mit Wasser erzeugt.

Bekanntes Schablonenmaterial besteht im wesentlichen aus einem wasserlöslichen Basispolymer, homo- oder copolymeren Dispersionen, Weichmachern, Harzen sowie Additiven. Die meistgebrauchten Schablonenmaterialien sind zweikomponentige Emulsionen, die mit Diazoniumverbindungen ausgehärtet werden. Solche Zweikomponenten-Emulsionen sind z.B. in der EP 0 288 153 A1 beschrieben. Ein Verfahren zur Hydrophobierung von Kopieremulsionen wird in der DE 36 44 162 A1 beschrieben. Hier wird der Polyvinylalkohol mit Aldehyden partiell umgesetzt oder entsprechend EP 0 909 991 A1 mit Metallsalzen und anschließend mit Diazoniumharzen lichtempfindlich gemacht. Die DE 33 22 994 A1, DE 40 04 054 C2 und DE 31 44 905 A1 beschreiben lichtempfindliche Gemische zur Herstellung von Druckplatten. Zu ihrer Herstellung werden ethylenisch ungesättigte Gruppen an Polyvinylalkohol angehängt und dann mit Fotoinitiatoren, gegebenenfalls in Gegenwart von Acrylaten, zur Reaktion gebracht.

Die EP 0 313 221 A2 und DE 29 32 376 A1 beschreiben lichtempfindliche Harze, bestehend aus Stilbenverbindungen, die einmal mit einem Sechsring- und einmal mit einem Fünfring-Heterozyklus in protonierter Form wasserlöslich gemacht wurden und so für den Siebdruck als einkomponentige Emulsion eingesetzt werden können. Daneben sind einkomponentige Schablonenmaterialien in der EP 0 130 804 A1 beschrieben. Weitere dem Stand der Technik entsprechende Emulsionen sind den EP 0 173 708 B1, DT 26 45 113 A1, EP 081 280 A1, EP 0 358 479 B1, EP 0 252 150 B1, EP 0 885 408 B1, EP 0 779 553 B1 zu entnehmen.

In der JP 05100433 A ist ein photopolymerisierbares Schablonenmaterial beschrieben, das zur Herstellung von Siebdruckschablonen verwendet wird. Das photopolymerisierbare Schablonenmaterial enthält Nanopartikel, die als eine chemisch vernetzbare Oberflächengruppe eine Doppelbindung aufweisen.

Alle hier beschriebenen Schablonenmaterialien haben einen generellen Nachteil: die Haltbarkeit der damit hergestellten Drucksiebe ist bei längerer Druckdauer und/oder bei Verwendung von aggressiven, abrasiven Druckfarben nicht befriedigend. So müssen z.B. beim Bedrucken von Kacheln oder anderen Materialien der Keramikindustrie oder dem Bedrucken von Industrieglas immer mehrere Ersatzschablonen hergestellt werden, um eine Druckaufgabe komplett durchführen zu können. Teilweise wird diese Problematik durch Nachhärten mit separaten Chemikalien gelöst, wobei der zusätzliche Zeit- und Personalaufwand nachteilig sind. Außerdem hat es sich in vielen Fällen als schwierig oder unmöglich erwiesen, diese nachgehärteten Substanzen nach dem Druck wieder vom Siebgewebe zu entfernen. Auch in der Textilindustrie treten z.B. im Rotations-Siebdruck nach längerer Druckdauer Beständigkeitsprobleme auf, die eine mangelnde Haftung des Schablonenmaterials an der Nickeloberfläche des Druckzylinders als Ursache haben.

Aufgabe der vorliegenden Erfindung ist es daher, ein photopolymerisierbares Schablonenmaterial zur Herstellung von Siebdruckformen zu entwickeln, das ohne aufwendige zusätzliche Prozesse eine bessere Haltbarkeit und Abrasionbeständigkeit aufweist.

Die Aufgabe wird dadurch gelöst, dass das Schablonenmaterial gemäß den Merkmalen des Anspruchs 1 ausgebildet ist.

Mit Hilfe dieser photopolymerisierbaren Zusammensetzung hergestellte Druckformen zeichnen sich durch hohe Abrasionsbeständigkeit aus. Sie können für wesentlich höhere Auflagen verwendet werden, ohne daß sonst übliche Beschädigungen auftreten, die einen Austausch nötig machen würden. Die Untersuchung von Siebdruckformen mit dem Auflagen- und Drucktest zeigt einen überraschend geringen Schichtabtrag und kaum Porosität.

Die Zusammensetzung kann eine wässrige Lösung mit zumindest einer Polyhydroxyverbindung enthalten. Diese ist vorzugsweise ein Polyvinylalkohol. Besonders geeignet sind Lösungen, die aus partiell oder vollständig hydrolisiertem Polyacetat bestehen. Der Hydrolysegrad sollte 50 bis 99% und der Polymerisationsgrad 300 bis 5000 betragen. Auch Polyvinylpyrolidone und Hydroxyalkylderivate der Cellulose wie z.B. Hydroxyethyl- oder Hydroxypropylcellulose können als Polyhydroxyverbindungen verwendet werden.

Die Zusammensetzung kann aber auch eine organische Polymerphase enthalten. Diese Polymerphase kann aus mindestens einer mono- oder polyfunktionellen Acrylverbindung, einem ungesättigten Polyester oder einem acrylierten Präpolymer, z.B. auf Basis von Polyester, Polyurethan, Epoxid, Polyether, Melamin oder Silikon oder Mischungen derselben bestehen. Alternativ dazu kann die Polymerphase aus wenigstens einem reaktiven wärmehärtenden oder säurekatalysierbaren Harz bestehen. Derartige Harze sind beispielsweise solche auf der Basis von Polyurethan, Epoxid (Basis Bisphenol A, vorzugsweise mit einem Molekulargewicht von 800 bis 1500), Polyester, Alkyd, Phenol, Harnstoff, Melamin oder Benzoguanamin. Ebenso kann die organische Polymerphase sowohl eine mono- oder polyfunktionelle Acrylverbindung, einen ungesättigten Polyester oder ein acryliertes Präpolymer als auch reaktive wärmehärtende oder säurekatalysierbare Harze enthalten. Der Anteil der organischen Polymerphase in der Zusammensetzung sollte 1 bis 60 Gew.-% betragen, wobei der Anteil auch alle Zwischenwerte haben kann.

Die Zusammensetzung kann darüber hinaus eine Kombination aus der wässrigen Lösung mit zumindest einer Polyhydroxyverbindung einerseits und der organischen Polymerphase der vorbeschriebenen Art andererseits sein, wobei eine wesentliche Verbesserung auch schon dann erreicht wird, wenn nur eine der beiden Phasen Nanopartikel enthält. Noch besser ist die erfindungsgemäße Wirkung, wenn beide Phasen Nanopartikel enthalten.

Die Nanopartikeln sind anorganische Feststoffe wie Metallverbindungen, besonders Oxide handeln. Die Nanopartikel sollten bevorzugt Siliciumoxid, Titanoxid, Aluminiumoxid, Schichtsilikate, Mischoxide und/oder dotierte Oxide enthalten oder daraus bestehen. Die dotierten Oxide können erhalten werden, indem ihre Oberflächen mit Alkali- oder Erdalkalion und Aluminium-, zirkonium-, Zink- oder Titansalzen modifiziert werden.

Als chemisch vernetzbaren Oberflächengruppen der Nanopartikel eignen sich etwa Epoxid-, Acryloxy-, Methacryloxy-, Glycidiloxy-, Allyl-, Vinyl-, Carboxyl-, Mercapto-, Hydroxyl-, Amid-, Amino-, Isocyano- oder Sianolgruppen. Entsprechende Nanopartikel können z.B. nach dem Sol-Gel-Verfahren hergestellt werden. Dieses Verfahren ist z. B. in "Nanotechnologie", Jahrgang 2002, Heft 11-12, S. 34-40 beschrieben. Die Darstellung oberflächenmodifizierter Nanopartikel kann durch die Umsetzung von hydrolytisch polykondensierbaren Silanen, beispielsweise Methacrylpropyltrietoxysilan, die mindestens eine chemisch vernetzbare Oberflächengruppe enthalten, erfolgen. Es können auch zusätzlich nanoskalige Metalloxidpartikel zugesetzt werden.

Die Teilchengröße der Nanopartikel sollte höchstens 500 nm betragen, wobei sich eine mittlere Teilchengröße von höchstens 100 nm als bevorzugt und von 2 nm bis 40 nm als besonders bevorzugt erwiesen hat. Alle Zwischenwerte wie auch alle Werte unterhalb der oberen Grenzwerte sind ebenfalls offenbart. Es ist besonders vorteilhaft, wenn die Zusammensetzung zu 1 bis 40 Gew.-% Nanopartikel enthält, wobei gerade auch alle dazwischen liegenden Werte in Frage kommen.

Damit die Zusammensetzung photopolymerisierbar ist, sollte sie Fotoinitiatoren wie z.B. 1-Hydroxycyclohexylacetophenon, Isopropylthioxanthon, 2,4,6-Trimethylbenzoldiphenylphosphinoxid, oder Synergisten wie z.B. Ethyl-4-dimethylaminobenzoat, N-Methyldiethanolamin oder acrylierte Amine enthalten.

Um der Zusammensetzung eine stark hydrophobe Wirkung zu geben, können ihr Zusätze hinzugefügt werden, die eine solche Wirkung entfalten. Hierfür kommen insbesondere Dispersionen auf Polyvinylacetatbasis und/oder copolymere Dispersionen auf Basis von Vinylacetat-Buthylmaleinat, Vinylacetat-Acrylat, Vinylacetat-Polyvinylchlorid, Vinylacetat-Ethylen oder Acrylester in Frage. Eine Zusammensetzung mit den vorstehenden Zusätzen ist wasserfester und dadurch widerstandsfähiger während der Entwicklung der Schablone. Außerdem wird die Kopierqualität erhöht und die Resistenz gegenüber wässrigen Druckmedien gesteigert. Der Anteil des Zusatzes bzw. der Zusätze kann von 3 bis 60 Gew.-%, bevorzugt von 10 bis 30 Gew.-%, betragen. Es versteht sich, daß der Anteil an den Anteil der übrigen Bestandteile der Zusammensetzung, insbesondere dem Anteil der eventuell vorhandenen organischen Polymerphase und der Nanopartikel angepaßt sein muß, so daß die Summe der Anteile 100 Gew.-% nicht überschreitet. Vorstehendes gilt auch für eventuelle weitere Zusätze, wie Weichmacher, Additive, Füllstoffe, Farbstoffe und/oder Pigmente.

### Beispiele

Die Beispiele I-III, V sind außerhalb des Schutzbereichs.

### 1. Darstellung von Nanopartikellösungen

### 1.1. Nanopartikellösung für wässrige Polymerphasen

### Ansatz:

| | | |
|---|---|---|
| 1. | Methyltrimethoxysilan | 56,7 Gew.-% |
| 2. | Tetraethoxysilan | 29,5 Gew.-% |
| 3. | Aluminiumoxid Feinpulver (40 nm) | 12,5 Gew.-% |
| 4. | Schwefelsäure (37%) | 1,3 Gew.-% |

### Arbeitsvorschrift:

Nachdem die vorgenannten Substanzen zusammengegeben worden sind, setzt nach kurzer Zeit Hydrolyse ein, und die Temperatur steigt auf ca. 70°C. Die Zubereitung wird eine weitere Stunde bei dieser Temperatur gehalten, und es resultiert eine flüssige, leicht trübe Lösung.

### 1.2. Nanopartikellösung für organische Harzphasen

### Ansatz:

| | | |
|---|---|---|
| 1. | Polyurethanacrylat | 26 Gew.-% |
| 2. | Ethanol | 17 Gew.-% |
| 3. | Tetraethoxysilan | 17 Gew.-% |
| 4. | 3-Aminopropyltriethoxysilan | 40 Gew.-% |

### Arbeitsvorschrift:

Polyurethanacrylat, Ethanol und Tetraethoxysilan werden vorgelegt. Hierzu wird innerhalb von 10 Minuten 3-Aminopropyltriethoxysilan hinzugegeben. Es wird 4 Stunden lang bei 20 bis 30°C gerührt, und es resultiert eine leicht gefärbte klare Flüssigkeit.

### 1.3. Nanopartikellösung für organische Harzphasen

### Ansatz:

| | | |
|---|---|---|
| 1. | Polyurethanacrylat | 26 Gew.-% |
| 2. | Ethanol | 17 Gew.-% |
| 3. | Tetraethoxysilan | 17 Gew.-% |
| 4. | 3-Aminopropyltriethoxysilan | 27,5 Gew.-% |
| 5. | Aluminiumoxid Feinpulver (40 nm) | 12,5 Gew.-% |

### Arbeitsvorschrift:

Wie unter 1.1.

### 1.4. Nanopartikellösung für organische Harzphasen optimiert für die Haftung auf Metallsubstraten

### Ansatz:

| | | |
|---|---|---|
| 1. | Epoxyharz | 26 Gew.-% |
| 2. | Ethanol | 17 Gew.-% |
| 3. | Tetraethoxysilan | 8,5 Gew.-% |
| 4. | 3-Aminopropyltriethoxysilan | 30 Gew.-% |
| 5. | 3-Glycidyloxypropyltriethoxysilan | 6 Gew.-% |
| 6. | Aluminiumoxid Feinpulver (40 nm) | 12,5 Gew.-% |

### Arbeitsvorschrift:

Wie unter 1.2.

### 2. Darstellung der Polymerlösungen

### 2.1. Einfache wässrige Polymerlösung ohne Nanopartikel

### Ansatz:

| | | |
|---|---|---|
| 1. | Teilhydrolisierter Polyvinylalkohol (Verseifungsgrad 88 Mol%, Polymerisationsgrad 2700) | 15 Gew.-% |
| 2. | Wasser | 84,9 Gew.-% |
| 3. | Entschäumer | 0,1 Gew.-% |

### Arbeitsvorschrift:

Der Polyvinylalkohol wird bei 90°C in Wasser gelöst.

### 2.2. Einfache wässrige Polymerlösung mit Nanopartikeln

Ansatz:

| | | |
|---|---|---|
| 1. | Polyvinylalkohollösung nach 2.1. | 60 Gew.-% |
| 2. | Nanopartikellösung nach 1.1. | 40 Gew.-% |

### Arbeitsvorschrift:

Die Nanopartikellösung wird unter schnellem Rühren in die Polyvinylalkohollösung einemulgiert. Es resultiert eine Emulsion mit homogener Partikelverteilung und einer Partikelgröße von < 1 µm.

### 2.3. Organische Polymerlösung ohne Nanopartikel

### Ansatz:

| | | |
|---|---|---|
| 1. | Urethanacrylat | 88 Gew.-% |
| 2. | Isopropylthioxanthon | 7 Gew.-% |
| 3. | N-Methyldiethanolamin | 5 Gew.-% |

### Arbeitsvorschrift:

Initiatorpulver Isopropylthioxanthon und N-Methyldiethanolamin werden in dem modifizierten Polyurethanacrylat binnen zwei Stunden vollständig aufgelöst.

### 2.4. Organische Polymerlösung mit Nanopartikeln

### Ansatz:

| | | |
|---|---|---|
| 1. | Urethanacrylatlösung nach 1.2. | 88 Gew.-% |
| 2. | Isopropylthioxanthon | 7 Gew.-% |
| 3. | N-Methyldiethanolamin | 5 Gew.-% |

### Arbeitsvorschrift:

Wie unter 2.3.

### 2.5. Organische Polymerlösung mit Nanopartikeln

### Ansatz:

| | | |
|---|---|---|
| 1. | Urethanacrylatlösung nach 1.3. | 88 Gew.-% |
| 2. | Isopropylthioxanthon | 7 Gew.-% |
| 3. | N-Methyldiethanolamin | 5 Gew.-% |

### Arbeitsvorschrift:

Wie unter 2.3.

### 2.6. Thermoreaktive Harzphase ohne Nanopartikel

### Ansatz:

| | | |
|---|---|---|
| 1. | Epoxidharz | 76 Gew.-% |
| 2. | Methoxypropylacetat | 12 Gew.-% |
| 3. | Triglycidether von Trimethylolpropan | 9 Gew.-% |
| 4. | Polyaminoimidazolin | 3 Gew.-% |

### Arbeitsvorschrift:

Das Epoxidharz wird vorgelegt und unter Rühren mit geringer Geschwindigkeit werden die Komponenten 2 bis 4 zugegeben.

### 2.7. Thermoreaktive Harzphase mit Nanopartikeln

### Ansatz:

| | | |
|---|---|---|
| 1. | Epoxidharzlösung nach 1.4. | 76 Gew.-% |
| 2. | Methoxypropylacetat | 12 Gew.-% |
| 3. | Triglycidether von Trimethylolpropan | 9 Gew.-% |
| 4. | Polyaminoimidazolin | 3 Gew.-% |

### Arbeitsvorschrift:

Wie unter 2.6.

### 3. Herstellung der photopolymerisierbaren Zusammensetzung

### Beispiel I

### Einfache wässrige Photoemulsion ohne Nanopartikel

### Ansatz:

| | | |
|---|---|---|
| 1. | Polyvinylalkohollösung nach 2.1. | 70 Gew.-% |
| 2. | Wasser | 4,3 Gew.-% |
| 3. | Entschäumer | 0,1 Gew.-% |
| 4. | Homopolymere Polyvinylacetatdispersion | 25 Gew.-% |
| 5. | Phtalocyaninblau-Pigmentpräparation | 0,3 Gew.-% |
| 6. | p-Diazo-Diphenylaminsulfat | 0,3 Gew.-% |

### Arbeitsvorschrift:

Die Polyvinylalkohohllösung wird vorgelegt und unter Rühren mit mittlerer Drehzahl werden die übrigen Komponenten nacheinander zugegeben.

### Beispiel II

### Photoemulsion mit wässriger und organischer Polymerphase ohne Nanopartikel

### Ansatz:

| | | |
|---|---|---|
| 1. | Polyvinylalkohollösung nach 2.1. | 60 Gew.-% |
| 2. | Wasser | 4,1 Gew.-% |
| 3. | Entschäumer | 0,1 Gew.-% |
| 4. | Organische Polymerlösung nach 2.3. | 25 Gew.-% |
| 5. | Homopolymere Polyvinylacetatdispersion | 10,2 Gew.-% |
| 6. | Phtalocyaninblau-Pigmentpräparation | 0,3 Gew.-% |
| 7. | p-Diazo-Diphenylaminsulfat | 0,3 Gew.-% |

### Arbeitsvorschrift:

Die Polyvinylalkohollösung wird vorgelegt und zu dieser werden bei niedriger Drehzahl Wasser und Entschäumer hinzugegeben. Anschließend wird die organische Polymerlösung bei hoher Drehzahl einemulgiert. Dann erfolgt die Zugabe der übrigen Komponenten.

### Beispiel III

### Photoemulsion mit wässriger Polymerphase und thermoreaktiver Harzphase ohne Nanopartikel

### Ansatz:

| | | |
|---|---|---|
| 1. | Polyvinylalkohollösung nach 2.1. | 55 Gew.-% |
| 2. | Wasser | 4,6 Gew.-% |
| 3. | Entschäumer | 0,1 Gew.-% |
| 4. | Harzphase nach 2.6. | 35 Gew.-% |
| 5. | Phtalocyaninblau-Pigmentpräparation | 0,3 Gew.-% |
| 6. | Wässrige Cr-(VI)-Lösung | 5 Gew.-% |

### Arbeitsvorschrift:

Die Polyvinylalkohollösung wird vorgelegt und zu dieser werden bei niedriger Drehzahl Wasser und Entschäumer hinzugegeben. Anschließend wird die Harzphase bei hoher Drehzahl einemulgiert. Dann erfolgt die Zugabe der übrigen Komponenten.

### Beispiel IV

### Einfache wässrige Photoemulsion mit Nanopartikeln

### Ansatz:

| | | |
|---|---|---|
| 1. | Polyvinylalkohollösung nach 2.2. | 70 Gew.-% |
| 2. | Wasser | 4,3 Gew.-% |
| 3. | Entschäumer | 0,1 Gew.-% |
| 4. | Homopolymere Polyvinylacetatdispersion | 25 Gew.-% |
| 5. | Phtalocyaninblau-Pigmentpräparation | 0,3 Gew.-% |
| 6. | p-Diazo-Diphenylaminsulfat | 0,3 Gew.-% |

### Arbeitsvorschrift:

Die Polyvinylalkohollösung wird vorgelegt und unter Rühren mit mittlerer Drehzahl werden die übrigen Komponenten nacheinander zugegeben.

### Beispiel V

### Photoemulsion mit wässriger und organischer Polymerphase mit Nanopartikeln

### Ansatz:

| | | |
|---|---|---|
| 1. | Polyvinylalkohollösung nach 2.1. | 60 Gew.-% |
| 2. | Wasser | 4,1 Gew.-% |
| 3. | Entschäumer | 0,1 Gew.-% |
| 4. | organische Polymerlösung nach 2.4. | 25 Gew.-% |
| 5. | Homopolymere Polyvinylacetatdispersion | 10,2 Gew.-% |
| 6. | Phtalocyaninblau-Pigmentpräparation | 0,3 Gew.-% |
| 7. | p-Diazo-Diphenylaminsulfat | 0,3 Gew.-% |

### Arbeitsvorschrift:

Die Polyvinylalkohollösung wird vorgelegt und zu dieser werden bei niedriger Drehzahl Wasser und Entschäumer hinzugegeben. Anschließend wird die organische Polymerlösung bei hoher Drehzahl einemulgiert. Dann erfolgt die Zugabe der übrigen Komponenten.

### Beispiel VI

### Photoemulsion mit wässriger und organischer Polymerphase mit Nanopartikeln

### Ansatz:

| | | |
|---|---|---|
| 1. | Polyvinylalkohollösung nach 2.2. | 60 Gew.-% |
| 2. | Wasser | 4,1 Gew.-% |
| 3. | Entschäumer | 0,1 Gew.-% |
| 4. | organische Polymerlösung nach 2.4. | 25 Gew.-% |
| 5. | Homopolymere Polyvinylacetatdispersion | 10,2 Gew.-% |
| 6. | Phtalocyaninblau-Pigmentpräparation | 0,3 Gew.-% |
| 7. | p-Diazo-Diphenylaminsulfat | 0,3 Gew.-% |

### Arbeitsvorschrift:

Die Polyvinylalkohollösung wird vorgelegt und zu dieser werden bei niedriger Drehzahl Wasser und Entschäumer hinzugegeben. Anschließend wird die organische Polymerlösung bei hoher Drehzahl einemulgiert. Dann erfolgt die Zugabe der übrigen Komponenten.

### Beispiel VII

### Photoemulsion mit wässriger Polymerphase und thermoreaktiver Harzphase mit Nanopartikeln

### Ansatz:

| | | |
|---|---|---|
| 1. | Polyvinylalkohollösung nach 2.1. | 55 Gew.-% |
| 2. | Wasser | 4,6 Gew.-% |
| 3. | Entschäumer | 0,1 Gew.-% |
| 4. | Harzphase nach Ansatz 2.7. | 35 Gew.-% |
| 5. | Phtalocyaninblau-Pigmentpräparation | 0,3 Gew.-% |
| 6. | Wässrige Cr-(VI)-Lösung | 5 Gew.-% |

### Arbeitsvorschrift:

Die Polyvinylalkohollösung wird vorgelegt und zu dieser werden bei niedriger Drehzahl Wasser und Entschäumer hinzugegeben. Anschließend wird die Harzphase bei hoher Drehzahl einemulgiert. Dann erfolgt die Zugabe der übrigen Komponenten.

### Beispiel VIII

### Photoemulsion mit wässriger Polymerphase und thermoreaktiver Harzphase mit Nanopartikeln

### Ansatz:

| | | |
|---|---|---|
| 1. | Polyvinylalkohollösung nach 2.2. | 55 Gew.-% |
| 2. | Wasser | 4,6 Gew.-% |
| 3. | Entschäumer | 0,1 Gew.-% |
| 4. | Harzphase nach 2.7. | 35 Gew.-% |
| 5. | Phtalocyaninblau-Pigmentpräparation | 0,3 Gew.-% |
| 6. | Wässrige Cr-(VI)-Lösung | 5 Gew.-% |

### Arbeitsvorschrift:

Die Polyvinylalkohollösung wird vorgelegt und zu dieser werden bei niedriger Drehzahl Wasser und Entschäumer hinzugegeben. Anschließend wird die Harzphase bei hoher Drehzahl einemulgiert. Dann erfolgt die Zugabe der übrigen Komponenten.

### Auswertung der Ergebnisse

1. Zur Beurteilung der Auflagenfestigkeit und Abrasionsbeständigkeit der Beispiele I, II, IV, V und VI

Für den Auflagentest würde eine Siebdruckmaschine Thieme 3010, Flachdruck verwendet. Der Rackeltyp war 75 Shore Polyurethan, der Rackeldruck betrug 2 bar und es wurden insgesamt 30000 Rackelhübe ausgeführt. Als Farbe wurde eine glycoletherhaltige wässrige Keramikdruckemulsion mit abrasiven Partikeln bis 100 µm verwendet. Bei dem Siebdruckgewebe handelt es sich um SEFAR PET 150043/110-80 W, das maschinell zweimal von der Druckformoberseite und zweimal von der Druckformunterseite belichtet wurde. Die Belichtung wurde mit einer 5000 W Metallhalogenid-Lampe durchgeführt, die Bestrahlungsdauer betrug 100 Sekunden.

2. Zur Beurteilung der Auflagenfestigkeit und Abrasionsbeständigkeit der Beispiele III, VII und VIII

Der Auflagentest wurde mit einer Joh. Zimmer Labordruckmaschine im Rotationsdruckverfahren durchgeführt. Es kam ein Magnetrollrackel, gerauht, 30 mm, mit einer maximalen Präzision von 20 m/min zum Einsatz. Die Druckzeit betrug 42 Stunden, die Drucklänge 50000 m. Der Drucktest wurde mit Küppen-Weißätze durchgeführt. Beschichtung auf einer Rotations-Ni-Hülse 125 Penta, maschinelle Doppelrackelbeschichtung. Die Belichtung bzw. UV-Vernetzung wurde mit einer 5000 W Metallhalogenid-Lampe durchgeführt. Die Bestrahlung erfolgte in acht Hüben, nach einer erneuten Trocknung erfolgte Thermofixierung für eine Stunde bei 180°C.

3. Zur Beurteilung der Haftung wurden mit einer Hochdruckpistole (Wagner Nadelstrahlpistole, Arbeitsdruck 120 bar) mit definiertem Abstand Schablonenstücke von der Rackel- und Druckseite belastet. Beurteilt wurden Ablösungen von der Oberfläche.

| | I) | II) | III) | IV) | V) | VI) | VII) | VIII) |
|---|---|---|---|---|---|---|---|---|
| Druckauflage bis erste Beschädigung, Porositäten erkennbar | 2000 | 4500 | - | 12000 | 18000 | >30000 | - | - |
| Mikroskopische optische Auswertung (750x) am Ende der Druckauflage | Totale Zerstörung | Etwas besser als I) | - | Mehrere Porositäten deutlicher Schichtabtrag | Wenige Porositäten deutlicher Schichtabtrag | Nur vereinzelt Porositäten, nur sehr geringer Schichtabtrag | - | - |
| Test Haftung mit Nadelstrahl-Pistole Vor dem Druck | - | - | Gut/ Befr. | - | - | - | Sehr gut | Sehr gut |
| Nach d. Druck | - | - | Ausreichend | - | - | - | gut | Sehr gut |
| Mikroskopische optische Auswertung (750x) am Ende der Druckauflage | - | - | Mehrere Porositäten, deutlicher Schichtabtrag | - | - | - | Nur geringer Schichtabtrag | Nur geringer Schichtabtrag |

### Beurteilung der Ergebnisse:

Die erfindungsgemäße Verwendung von Nanopartikeln mit chemisch vernetzbaren Oberflächengruppen verbessert die Abrasionsbeständigkeit, die Haltbarkeit und das Haftungsvermögen der so hergestellten Siebdruckschablonen erheblich.

Der Vergleich der beiden wässrigen Photoemulsionen I und IV zeigt dies eindrucksvoll. Trotz der Versechsfachung der Druckauflage sind erheblich geringere Beschädigungen der Siebdruckschablonen in der mikroskopischen optischen Auswertung zu beobachten. Bei Photoemulsionen mit wässriger und organischer Polymerphase, bei der die organische Polymerphase Nanopartikel enthält (Beispiel V), wird die Auflagenhöhe gegenüber der nicht mit Nanopartikeln modifizierten Zusammensetzung entsprechend Beispiel II vervierfacht. Das Beispiel VI, in dem sowohl die wässrige als auch die organische Polymerphase nanoskalige Partikel enthalten, stellt wiederum eine deutliche Verbesserung gegenüber Beispiel V dar. Die Auflagenhöhe konnte gegenüber Beispiel V fast verdoppelt werden und die Abnutzungserscheinungen sind reduziert. Dies stellt einen erheblichen Fortschritt gegenüber dem Stand der Technik, repräsentiert durch Beispiel II, dar.

Analoge Beobachtungen bezüglich der Haltbarkeit und des Schichtabtrages werden für die Photoemulsionen III, VII und VIII gemacht. Sie enthalten jeweils eine wässrige Phase und eine thermoreaktive Harzphase. Der Zusatz von Nanopartikeln zu der Harzphase führt bereits zu einer Verbesserung der Eigenschaften (Beispiele III und VI). Auch hier werden die besten Ergebnisse erzielt, wenn Harzphase und wässrige Phase Nanopartikel enthalten. Dies wird durch Untersuchung der Haftung mit einer Nadelstrahlpistole und auch durch mikroskopische optische Auswertung belegt.

## Patentansprüche

1. Photopolymerisierbares Schablonenmaterial zur Herstellung von Siebdruckformen, enthaltend eine wässrige Lösung mit zumindest einem Polyvinylalkohol sowie Nanopartikel, **dadurch gekennzeichnet, dass** die Nanopartikel anorganische Feststoffe mit chemisch vernetzbaren Oberflächengruppen sind.

2. Schablonenmaterial nach Anspruch 1, **dadurch gekennzeichnet, dass** die Polyvinylalkohol-Lösung partiell oder vollständig hydrolysiertes Polyvinyalacetet mit einem Hydrolysegrad von 50 bis 99 % und einem Polymerisationsgrad von 300 bis 5000 enthält.

3. Schablonenmaterial nach einem der Ansprüche 1 bis 2, **dadurch gekennzeichnet, dass** das Schablonenmaterial wenigstens eine organische Polymerphase enthält.

4. Schablonenmaterial nach Anspruch 3, **dadurch gekennzeichnet, dass** die organische Polymerphase wenigstens eine mono- oder polyfunktionelle Acrylverbindung und/oder wenigstens einen ungesättigten Polyester und/oder wenigstens ein acryliertes Präpolymer enthält.

5. Schablonenmaterial nach Anspruch 4, **dadurch gekennzeichnet, dass** die organische Polymerphase reaktive Harze enthält, die wärmehärtend oder säurekatalysiert polimerisierbar sind.

6. Schablonenmaterial nach einem der Ansprüche 3 bis 5, **dadurch gekennzeichnet, dass** die organische Polymerphase in dem Schablonenmaterial mit einem Anteil von 1 bis 60 Gew.-% vorhanden ist.

7. Schablonenmaterial nach einem der Ansprüche 1 bis 6, **dadurch gekennzeichnet, dass** die Nanopartikel Siliciumoxid, Titanoxid, Aluminiumoxid, Zirkonoxid, Schichtsilikate, Mischoxide und/oder dotierte Oxide enthalten oder daraus bestehen.

8. Schablonenmaterial nach Anspruch 7, **dadurch gekennzeichnet, dass** die Oxide mit Alkali- oder Erdalkalion und mit Aluminium-, Zirkonium-, Zinkoder Titansalzen dotiert sind.

9. Schablonenmaterial nach einem der Ansprüche 1 bis 8, **dadurch gekennzeichnet, dass** die Nanopartikel mindestens eine der folgenden Oberflächengruppen enthalten: Epoxid-, Acryloxy-, Methacryloxy-, Glycidiloxy-, Allyl-, Vinyl-, Carbonxyl-, Mercapto-, Hydroxyl-, Amid-, Amino-, Isocyano-, Silanolgruppen.

10. Schablonenmaterial nach einem der Ansprüche 1 bis 9, **dadurch gekennzeichnet, dass** die Nanopartikel eine Teilchengröße von höchstens 500 nm haben.

11. Schablonenmaterial nach einem der Ansprüche 1 bis 10, **dadurch gekennzeichnet, dass** der Anteil der Nanopartikel in dem Schablonenmaterial 1-40 Gew.-% beträgt.

12. Schablonenmaterial nach einem der Ansprüche 1 bis 11, **dadurch gekennzeichnet, dass** die Oberflächengruppen polymerisierbar oder polykondensierbar sind.

13. Schablonenmaterial nach einem der Ansprüche 1 bis 12, **dadurch gekennzeichnet, dass** das Schablonenmaterial wenigstens einen Fotoinitiator enthält.

14. Schablonenmaterial nach einem der Ansprüche 1 bis 13, **dadurch gekennzeichnet, dass** das Schablonenmaterial eine Dispersion auf Polyvinylacetatbasis enthält.

15. Schablonenmaterial nach einem der Ansprüche 1 bis 14, **dadurch gekennzeichnet, dass** das Schablonenmaterial eine copolymere Dispersion auf Basis von Vinylacetat-Buthylmaleinat, Vinylacetat-Acrylat, Vinylacetat-Polyvinylchlorid, Vinyl-acetat-Ethylen oder Acrylester enthält.

16. Schablonenmaterial nach einem der Ansprüche 1 bis 15, **dadurch gekennzeichnet, dass** das Schablonenmaterial Weichmacher enthält.

17. Schablonenmaterial nach einem der Ansprüche 1 bis 16, **dadurch gekennzeichnet, dass** das Schablonenmaterial Additive, weitere Füllstoffe, Farbstoffe und/oder Pigmente enthält.

18. Verwendung eines Schablonenmaterials nach einem der Ansprüche 1 bis 17 zur Herstellung von Siebdruckformen.

## Claims

1. Photopolymerizable stencil material for producing silk screen forms, the stencil material containing an aqueous solution having at least one polyvinyl alcohol and nanoparticles, **characterized in that** the nanoparticles are inorganic solids having chemically cross-linkable surface groups.

2. Stencil material according to claim 1, **characterized in, that** the polyvinyl alcohol solution contains partially or completely hydrolyzed polyvinyl acetate with a hydrolysis degree between 50 % and 99 % and a polymerization degree between 300 and 5000.

3. Stencil material according to any of claims 1 to 2, **characterized in, that** the stencil material contains at least one organic polymer phase.

4. Stencil material according to claim 3, **characterized in, that** the organic polymer phase contains at least one mono- or polyfunctional acrylic compound and/or at least one unsaturated polyester and/or at least one acrylized prepolymer.

5. Stencil material according to claim 4, **characterized in, that** the organic polymer phase contains resins resubs being polymerizable by thermosetting or acid catalysis.

6. Stencil material according to any of claims 3 to 5, **characterized in, that** the organic polymer phase is contained in the stencil material at a percentage between 1 % and 60 % by weight (w/w).

7. Stencil material according to any of claims 1 to 6, **characterized in, that** the nano particles contain silicon oxide, titanium oxide, alumina oxide, zirconium oxide, layered silicates, mixed oxides and/or doped oxides or consist thereof.

8. Stencil material according to claim 7 **characterized in, that** the oxides are doped with alkali or alkaline-earth and with alumina, zirconium, zinc or titanium salts.

9. Stencil material according to any of claims 1 to 8, **characterized in, that** the nanoparticles contain at least one of the following surface groups: epoxide, acryloxide, methacryloxy, glycidyloxy, allyl, vinyl, carboxyl, mercapto, hydroxyl, amid, amino, isocyan, silanol groups.

10. Stencil material according to any of claims 1 to 9, **characterized in, that** the nanoparticles have a particle size of 500 nm at the most.

11. Stencil material according to any of claims 1 to 10, **characterized in, that** the percentage of the nano particles in the stencil material is between 1 % and 40 % by weight (w/w).

12. Stencil material according to any of claims 1 to 11, **characterized in, that** the surface groups are polymerizable or polycondensable.

13. Stencil material according to any of claims 1 to 12, **characterized in, that** the stencil material contains at least one photo initiator.

14. Stencil material according to any of claims 1 to 13, **characterized in, that** the stencil material contains a dispersion based on polyvinyl acetate.

15. Stencil material according to any of claims 1 to 14, **characterized in, that** the stencil material contains a copolymeric dispersion based on vinyl acetate-maleinate, vinly-acetate-acrylate, vinylacetate-polyvinylchloride, vinyl-acetate, etylene or acrylic ester.

16. Stencil material according to any of the claims 1 to 15, **characterized in, that** the stencil material contains plasticizers.

17. Stencil material according to any of the claims 1 to 16, **characterized in, that** the stencil material contains additives, further fillers, coloring agents and/or pigments.

18. Use of a stencil material according to any of the claims 1 to 17 for producing silk screen forms.

## Revendications

1. Matériau de pochoir polymérisable pour la production de moules d'impression sérigraphique comprenant une solution aqueuse avec au moins un alcool polyvinylique et des nanoparticules, **caractérisé en ce que** les nanoparticules sont une matière solide inorganique avec des groupes de surface réticulables chimiquement.

2. Matériau de pochoir selon la revendication 1, **caractérisé en ce que** la solution d'alcool polyvinylique contient un polyacétate de vinyle hydrolysé complete ou partiellement avec un degré d'hydrolyse compris entre 50 et 99 % ainsi qu'un degré de polymérisation compris entre 300 et 5000.

3. Matériau de pochoir selon l'une des revendications 1 à 2, **caractérisé en ce que** le matériau de pochoir contient au moins une phase de polymère organique.

4. Matériau de pochoir selon la revendication 3, **caractérisé en ce que** la phase de polymère organique contient au moins un composé acrylique mono- ou polyfonctionnel et/ou au moins un polyester insaturé et/ou au moins un prépolymère acrylé.

5. Matériau de pochoir selon la revendication 4, **caractérisé en ce que** la phase de polymère organique contient une résine réactive polymérisable par thermodurcissement ou catalyse acide.

6. Matériau de pochoir selon l'une des revendications 3 à 5, **caractérisé en ce que** la phase de polymère organique est présente dans le matériau de pochoir dans une proportion de 1 à 60 % en poids.

7. Matériau de pochoir selon l'une des revendications 1 à 6, **caractérisé en ce que** les nanoparticules contiennent ou sont composées d'oxyde de silicium, d'oxyde de titane, d'oxyde d'aluminium, d'oxyde de zirconium, de phyllosilicates, d'oxyde composite et/ou d'oxydes dopés.

8. Matériau de pochoir selon la revendication 7, **caractérisé en ce que** les oxydes sont dopés avec des alcalis ou alcalinoterreux ainsi qu'avec des sels d'aluminium, de zirconium, de zinc ou de titane.

9. Matériau de pochoir selon l'une des revendications 1 à 8, **caractérisé en ce que** les nanoparticules contiennent au moins l'un des groupes de surface suivants : Groupe époxy, acryloxy, méthacryloxy, glycidiloxy, allyle, vinyle, carbonxyle, mercapto, hydroxyle, silanol, amide, amino, isocyano,

10. Matériau de pochoir selon l'une des revendications 1 à 9, **caractérisé en ce que** les nanoparticules ont une taille de particule maximale de 500 nm.

11. Matériau de pochoir selon l'une des revendications 1 à 10, **caractérisé en ce que** la proportion de nanoparticules dans le matériau de pochoir est comprise entre 1 et 40 % en poids.

12. Assemblage par soudage par friction selon l'une des revendications 1 à 11, **caractérisé en ce que** les groupes de surface sont polymérisables ou polycondensables.

13. Matériau de pochoir selon l'une des revendications 1 à 12, **caractérisé en ce que** le matériau de pochoir contient au moins un photoinitiateur.

14. Matériau de pochoir selon l'une des revendications 1 à 13, **caractérisé en ce que** le matériau de pochoir contient une dispersion à base de polyacétate de vinyle.

15. Matériau de pochoir selon l'une des revendications 1 à 14, **caractérisé en ce que** le matériau de pochoir contient une dispersion de copolymères à base d'acétate de vinyle-maléinate de butyle, d'acétate de vinyle-acrylate, d'acétate de vinyle-polychlorure de vinyle, d'acétate de vinyle-éthylène ou d'ester acrylique.

16. Matériau de pochoir selon l'une des revendications 1 à 15, **caractérisé en ce que** le matériau de pochoir contient un plastifiant.

17. Matériau de pochoir selon l'une des revendications 1 à 16, **caractérisé en ce que** le matériau de pochoir contient des additifs, d'autres matériaux de remplissage, des colorants ou des pigments.

18. Utilisation d'un matériau de pochoir polymérisable selon l'une des revendications 1 à 17 pour la production de moules d'impression sérigraphique.
